# EUROPEAN PATENT SPECIFICATION

(11) **EP 4 006 907 B1**
(45) Date of publication and mention of the grant of the patent: **07.02.2024**
(21) Application number: 21856927.5
(22) Date of filing: 21.06.2021
(51) Int. Cl.: G11C 29/02, G11C 29/12, G11C 7/04, G11C 7/22, G11C 29/50

(54) **METHOD FOR EVALUATING PERFORMANCE OF INTERFACE CIRCUIT AND RELATED DEVICE**
VERFAHREN ZUR BEWERTUNG DER LEISTUNG EINER SCHNITTSTELLENSCHALTUNG UND ZUGEHÖRIGE VORRICHTUNG
PROCÉDÉ POUR ÉVALUER LES PERFORMANCES D'UN CIRCUIT D'INTERFACE ET DISPOSITIF ASSOCIÉ

(30) Priority: 24.09.2020 CN 202011015986
(43) Date of publication of application: 01.06.2022
(73) Proprietor: Changxin Memory Technologies, Inc., Hefei City, Anhui 230601 (CN)
(72) Inventor: LIN, Feng, Hefei, Anhui 230601 (CN); WU, Zengquan, Hefei, Anhui 230601 (CN)
(74) Representative: Lavoix
(86) International application number: PCT/CN2021/101335
(87) International publication number: WO 2022/062504

(56) References cited:
- CN-A- 1 329 254
- CN-A- 108 535 631
- CN-A- 110 223 722
- CN-A- 110 928 731
- CN-A- 110 928 731
- US-A1- 2004 123 207
- US-A1- 2010 097 087
- US-A1- 2017 323 222
- US-A1- 2020 035 276
- US-A1- 2020 133 505

## Description

### CROSS-REFERENCE TO RELATED APPLICATIONS

The present application claims priority to Chinese patent application No. 202011015986.1, filed on September 24, 2020 and entitled "METHOD FOR EVALUATING PERFORMANCE OF INTERFACE CIRCUIT AND RELATED DEVICE".

### TECHNICAL FIELD

The disclosure relates to the technical field of a semiconductor, and more specifically to a method for evaluating performance of an interface circuit, an apparatus for evaluating performance of an interface circuit, an electronic device, and a computer-readable storage medium.

### BACKGROUND

With the rapid development of semiconductor memory devices, the demand for internal timing control over the semiconductor memory device is higher and higher in order to provide the semiconductor memory device with better performance.

During a write operation of a semiconductor circuit including the semiconductor memory, the semiconductor circuit may receive a data signal from a storage controller according to a data strobe signal provided from the storage controller. The received data signal can then be stored within the semiconductor memory.

Performance of an interface circuit seriously influences data reception reliability, and therefore, it is needed to provide a reliable evaluation method for effectively evaluating the performance of the interface circuit of the semiconductor circuit.

Related arts can be found in US 2020/035276 A1, US 2017/323222 A1, US 2004/123207 A1, CN 110 928 731 A and CN 110 223 722 A.

### SUMMARY

The invention is defined by a method and an apparatus for evaluating performance of a memory interface circuit according to independent claims 1 and 9, respectively, and a computer-readable storage medium according to independent claim 10.

Further preferred embodiments are defined in the dependent claims.

### BRIEF DESCRIPTION OF THE DRAWINGS

The accompanying drawings are incorporated in and constitute a part of the specification, illustrate embodiments consistent with the disclosure, and are used to explain the principle of the disclosure, together with the specification.
FIG. 1 schematically shows a flow diagram of a method for evaluating performance of an interface circuit according to one embodiment of the disclosure.
FIG. 2 schematically shows a flow diagram of a method for evaluating performance of an interface circuit according to one embodiment of the disclosure.
FIG. 3 schematically shows a processing flow diagram of S131 in FIG. 2 in an example embodiment.
FIG. 4 schematically shows a schematic diagram of a semiconductor memory according to the present invention.
FIG. 5 schematically shows a schematic diagram of a data strobe signal and a data valid window under different reference voltages according to one embodiment of the disclosure.
FIG. 6 schematically shows a schematic diagram of a data eye diagram according to one embodiment of the disclosure.
FIG. 7 schematically shows a schematic diagram of a data eye diagram according to one embodiment of the disclosure.
FIG. 8 schematically shows a schematic diagram of a composite eye diagram of an interface circuit according to the present invention.
FIG. 9 schematically shows a schematic diagram of a composite eye diagram under different process corners according to one embodiment of the disclosure.
FIG. 10 schematically shows a block diagram of an apparatus for evaluating performance of an interface circuit according to the present invention.

### DETAILED DESCRIPTION

Exemplary implementation modes will now be described more comprehensively with reference to the accompanying drawings. However, the example implementation modes can be implemented in various forms and should not be construed as limited by the examples set forth herein; rather, these implementation modes are provided so that the disclosure will be thorough and complete, and will fully convey the concept of the example implementation modes to those skilled in the art.

In addition, the described features, structures, or characteristics can be combined in one or more embodiments in any suitable mode. In the following description, a number of specific details are provided in order to provide a thorough understanding of the embodiment of the disclosure. However, it will be appreciated by those skilled in the art that the technical solution of the disclosure can be practiced without one or more of the specific details, or with other methods, elements, apparatuses, steps, and the like. In other cases, well-known methods, apparatuses, implementations, or operations are not shown or described in detail to avoid obscuring each aspect of the disclosure.

The block diagrams shown in the drawings are merely functional entities and do not necessarily have to correspond to physically independent entities. That is, the functional entities can be implemented in the form of software, or in at least one hardware module or integrated circuit, or in different networks and/or processor apparatuses and/or microcontroller apparatuses.

The flow diagrams shown in the drawings are merely exemplary descriptions, do not necessarily include all the content and operations/steps. For example, some operations/steps may also be broken down, while some operations/steps can be merged or partially merged.

Although relative terms such as "upper" and "lower" are used in the specification to describe a relative relationship of one assembly of the reference numeral to another assembly, these terms are used in the specification for convenience only, for example, according to an orientation of the example illustrated in the figures. It will be appreciated that if an apparatus of the reference numeral is turned upside down, the "upper" component described above will become the "lower" component. When a structure is "on" another structure, it may mean that the structure is integrally formed with the other structure, or that the structure is "directly" arranged on the other structure, or that the structure is "indirectly" arranged on the other structure through the other structure.

The terms "a", "an", "the", "said", and "at least one" are used to indicate the presence of one or more elements/constituent parts/and the like. The terms "including" and "having" are used in an open inclusive sense and mean that there can be additional elements/constituent parts/and the like. In addition to the listed elements/constituent parts/and the like. The terms "first" and "second", and the like are used only as labels and are not intended to limit the number of objects.

In the related art, in order to evaluate the performance of the interface circuit under power, voltage, and temperature variations, it is necessary to construct some specific test benches to evaluate the performance of the interface circuit. Meanwhile, in the design of the interface circuit of a high-speed semiconductor memory, it is difficult to completely evaluate a single-ended signal receiver (which can be represented by RX).

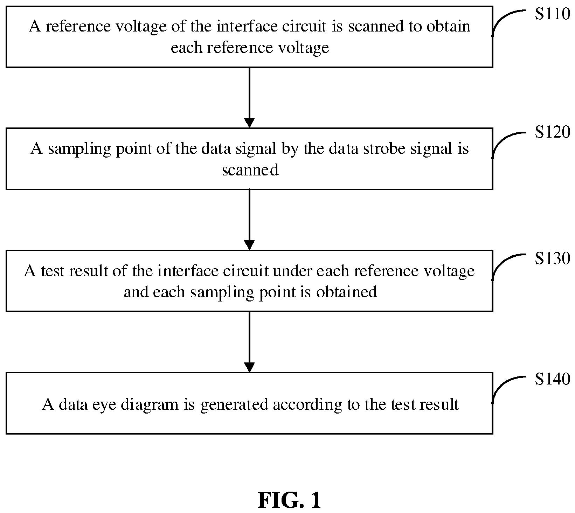

Aiming at the problems existing in the related art, the method provided by the embodiment of the disclosure can be used to solve at least one above problem. FIG. 1 schematically shows a flow diagram of a method for evaluating performance of an interface circuit according to one embodiment of the disclosure. The interface circuit can be configured to receive a data signal DQ according to a data strobe signal (DQS or WCK).

According to the present invention the interface circuit is the interface circuit of a semiconductor memory. In some embodiments, the interface circuit can be the interface circuit of the high-speed semiconductor memory. In some embodiments, the interface circuit can be the interface circuit of a mobile semiconductor memory. The disclosure does not make any limitation on it.

In the embodiment of the disclosure, the semiconductor memory can be any semiconductor memory, for example, a Double Data Rate Synchronous Dynamic Random-Access Memory (DDR SDRAM). When the semiconductor memories of different types and models are adopted, mark symbols adopted by the data strobe signal may vary, and the disclosure does not make any limitation on it.

As shown in FIG. 1, the method for evaluating performance of an interface circuit provided by the embodiment of the disclosure can include the following steps.

In S 110, a reference voltage of the interface circuit is scanned to obtain each reference voltage.

In order to generate a data eye diagram in the embodiment of the disclosure, the reference voltage of the interface circuit is scanned to obtain a plurality of reference voltages Vref.

In S 120, a sampling point of the data signal DQ by the data strobe signal (for example, DQS or WCK) is scanned.

In the following illustration, if the semiconductor memory being DDR 4 or Low Power DDR SDRAM4 (LPDDR) is taken as an example for illustration, the data strobe signal can be represented as the DQS, correspondingly, the following strobe-to-data time can be represented as tDQS2DQ, and the tDQS2DQ is the time difference tDQS2DQ between the data strobe signal DQS of the DDR4 or LPDDR4 and the data signal DQ. If the semiconductor memory is DDR5/LPDDR5, correspondingly, the following strobe-to-data time can be represented as tWCK2DQI, and the tWCK2DQI is the time difference tWCK2DQI between the data strobe signal WCK of the DDR5 or LPDDR5 and the data signal DQ.

In S 130, a test result of the interface circuit under each reference voltage and each sampling point is obtained.

In the embodiment of the disclosure, whether the test result of the interface circuit under each reference voltage and each sampling point passes (represented by p) or fails (represented by X) is obtained.

In S 140, a data eye diagram is generated according to the test result.

According to the test result obtained according to the above step and where the test result is obtained under which reference voltage and which sampling point, the data eye diagram can be generated.

According to the method for evaluating performance of an interface circuit provided by the implementation mode of the disclosure, through scanning of each sampling point of the data strobe signal to the data signal and through combination of each reference voltage obtained by scanning the reference voltage of the interface circuit, the test result of the interface circuit under each reference voltage and each sampling point can be obtained, the data eye diagram can thus be generated from these test results under each reference voltage and each sampling point, and the performance of the interface circuit can be effectively and reliably evaluated. In addition, the generated data eye diagram may also be utilized to quickly and accurately find the optimal target strobe-to-data time and/or target reference voltage of the interface circuit, so that the interface circuit may guarantee the accuracy of writing the data signal when receiving the data signal according to the data strobe signal. Both at pre-layout and post-layout, the method provided by the embodiment of the disclosure can be used to simulate to generate the data eye diagrams with the same accuracy.

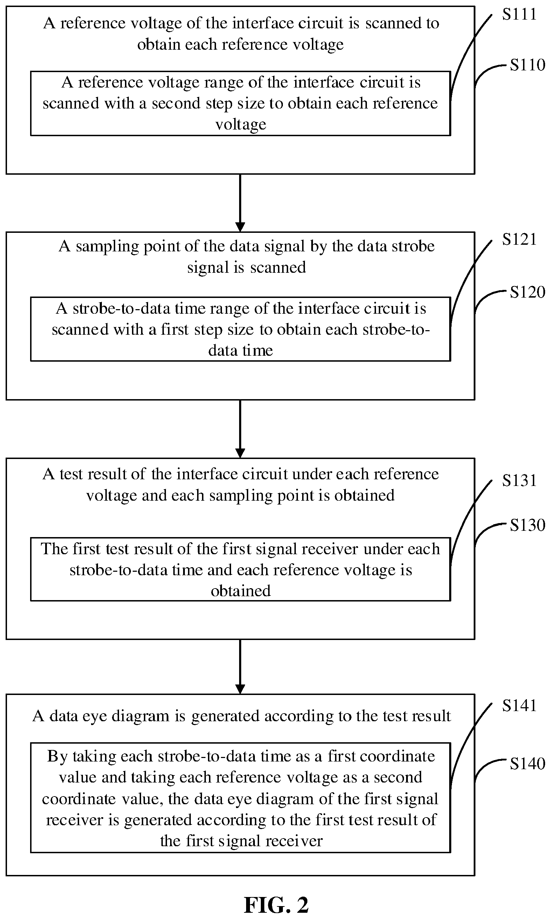

FIG. 2 schematically shows a flow diagram of a method for evaluating performance of an interface circuit according to one embodiment of the disclosure.

As shown in FIG. 2, S110 in the above embodiment of FIG. 1 includes S111. In S111, a reference voltage range of the interface circuit is scanned with a second step size to obtain each reference voltage.

The interface circuit has a corresponding reference voltage range, for example, the reference voltage Vref of the LPDDR4 is divided into two ranges (range [0]: VDDQ ranging from 10.0% to 30.0%, and range [1]: VDDQ ranging from 22.0% to 42.0%) as specified in a Joint Electron Device Engineering Council (JEDEC) standard. The step size of the two ranges is 0.4%. The two voltage reference ranges have an overlapping part, as shown in the following Table 1.

In the following illustration, the reference voltage ranges being the above range [0] and range [1] are taken as an example for illustration. However, it is to be noted that different protocols have different reference voltage ranges and step sizes, and therefore, the embodiment of the disclosure is not limited to the above illustration.

**Table 1**

| Function | Oper -and | Range[0] Values (% of VDDQ) | | Range[1] Values (% of VDDQ) | |
|---|---|---|---|---|---|
| V_{ref} is set through a register | OP [5:0] | 000000_{B}:10.0 % | 011010_{B}:20.4 % | 000000_{B}:22.0 % | 011010_{B}:32.4 % |
| | | 000001_{B}:10.4 % | 011011_{B}:20.8 % | 000001_{B}:22.4 % | 011011_{B}:32.8 % |
| | | 000010_{B}:10.8 % | 011100_{B}:21.2 % | 000010_{B}:22.8 % | 011100_{B}:33.2 % |
| | | 000011_{B}:11.2 % | 011101_{B}:21.6 % | 000011_{B}:23.2 % | 011101_{B}:33.6 % |
| | | 000100_{B}:11.6 % | 011110_{B}:22.0 % | 000100_{B}:23.6 % | 011110_{B}:34.0 % |
| | | 000101_{B}:12.0 % | 011111_{B}:22.4 % | 000101_{B}:24.0 % | 011111_{B}:34.4 % |
| | | 000110_{B}:12.4 % | 100000_{B}:22.8 % | 000110_{B}:24.4 % | 100000_{B}:34.8 % |
| | | 000111_{B}:12.8 % | 100001_{B}:23.2 % | 000111_{B}:24.8 % | 100001_{B}:35.2 % |
| | | 001000_{B}:13.2 % | 100010_{B}:23.6 % | 001000_{B}:25.2 % | 100010_{B}:35.6 % |
| | | 001001_{B}:13.6 % | 100011_{B}:24.0 % | 001001_{B}:25.6 % | 100011_{B}:36.0 % |
| | | 001010_{B}:14.0 % | 100100_{B}:24.4 % | 001010_{B}:26.0 % | 100100_{B}:36.4 % |
| | | 001011_{B}:14.4 % | 100101_{B}:24.8 % | 001011_{B}:26.4 % | 100101_{B}:36.8 % |
| | | 001100_{B}:14.8 % | 100110_{B}:25.2 % | 001100_{B}:26.8 % | 100110_{B}:37.2 % |
| | | 001101_{B}:15.2 % | 100111_{B}:25.6 % | 001101_{B}:27.2 % (default) | 100111_{B}:37.6 % |
| | | 001110_{B}:15.6 % | 101000_{B}:26.0 % | 001110_{B}:27.6 % | 101000_{B}:38.0 % |
| | | 001111_{B}:16.0 % | 101001_{B}:26.4 % | 001111_{B}:28.0 % | 101001_{B}:38.4 % |
| | | 010000_{B}:16.4 % | 101010_{B}:26.8 % | 010000_{B}:28.4 % | 101010_{B}:38.8 % |
| | | 010001_{B}:16.8 % | 101011_{B}:27.2 % | 010001_{B}:28.8 % | 101011_{B}:39.2 % |
| | | 010010_{B}:17.2 % | 101100_{B}:27.6 % | 010010_{B}:29.2 % | 101100_{B}:39.6 % |
| | | 010011_{B}:17.6 % | 101101_{B}:28.0 % | 010011_{B}:29.6 % | 101101_{B}:40.0 % |
| | | 010100_{B}:18.0 % | 101110_{B}:28.4 % | 010100_{B}:30.0 % | 101110_{B}:40.4 % |
| | | 010101_{B}:18.4 % | 101111_{B}:28.8 % | 010101_{B}:30.4 % | 101111_{B}:40.8 % |
| | | 010110_{B}:18.8 % | 110000_{B}:29.2 % | 010110_{B}:30.8 % | 110000_{B}:41.2 % |
| | | 010111_{B}:19.2 % | 110001_{B}:29.6 % | 010111_{B}:31.2 % | 110001_{B}:41.6 % |
| | | 011000_{B}:19.6 % | 110010_{B}:30.0 % | 011000_{B}:31.6 % | 110010_{B}:42.0 % |
| | | 011001_{B}:20.0 % | all others: reserved | 011001_{B}:32.0 % | all others: reserved |

In the example embodiment, the second step size can include a third sub-step size and a fourth sub-step size. The third sub-step size is greater than the fourth sub-step size.

The operation that a reference voltage range of the interface circuit is scanned in a second step size to obtain each reference voltage can include: an edge reference voltage range on at least one side of the reference voltage range is determined; the third sub-step size of the edge reference voltage range is set; a middle reference voltage range except for the edge reference voltage range in the reference voltage range is determined; the fourth sub-step size of the middle reference voltage range is set; and the edge reference voltage range is scanned with the third sub-step size, and the middle reference voltage range is scanned with the fourth sub-step size to obtain each reference voltage.

For example, if each reference voltage Vref is taken as an ordinate value (second coordinate value), the reference voltage range at an upper side, or a lower side, or both the upper side and lower side of the reference voltage range can be taken as the edge reference voltage range, the scanning is performed with the relatively great third sub-step size in the edge reference voltage range to obtain each reference voltage in the edge reference voltage range, and the scanning is performed with the relatively small fourth sub-step size in the middle reference voltage range except for the above edge reference voltage range to obtain each reference voltage in the middle reference voltage range.

For another example, if each reference voltage Vref is taken as an abscissa value (second coordinate value), the reference voltage range at a left side, or a right side, or both the left side and right side of the reference voltage range can be taken as the edge reference voltage range, the scanning is performed with the relatively great third sub-step size in the edge reference voltage range to obtain each reference voltage in the edge reference voltage range, and the scanning is performed with the relatively small fourth sub-step size in the middle reference voltage range except for the above edge reference voltage range to obtain each reference voltage in the middle reference voltage range.

In the embodiment of the disclosure, on one hand, the scanning is performed with the relatively great third sub-step size to obtain each reference voltage in the edge reference voltage range, so that the number of the finally obtained total reference voltages can be reduced, the occupied storage space is reduced, the computation amount is reduced, and the speed of obtaining a target reference voltage can be increased subsequently; and on the other hand, since the target reference voltage to be obtained subsequently through the data eye diagram is generally located in the middle of the reference voltage range, the scanning is performed with the relatively small fourth sub-step to obtain each reference voltage in the middle reference voltage range, the precision of the obtained target reference voltage can be improved.

It is to be noted that although in the following illustration, the scanning being performed with unequal step sizes (the third sub-step size and the fourth sub-step size) to obtain each reference voltage is taken as an example for illustration, the disclosure is not limited here. In other embodiments, the entire reference voltage range may also be scanned with an equal step size to obtain each reference voltage.

In the embodiment of FIG. 2, S120 in the above embodiment of FIG. 1 includes S121. In S121, a strobe-to-data time range of the interface circuit is scanned with a first step size to obtain each strobe-to-data time.

The LPDDR4 is taken as an example, the strobe-to-data time is tDQS2DQ, and a tDQS2DQ range [T1, T2] can be [0 ps, 800 ps]. The LPDDR5 is taken as an example, the strobe-to-data time is tWCK2DQI, and a tWCK2DQI range [T1, T2] can be [0 ps, 700 ps].

In the example embodiment, the first step size can include a first sub-step size and a second sub-step size. The first sub-step size can be greater than the second sub-step size.

The operation that a strobe-to-data time range of the interface circuit is scanned in a first step size to obtain each strobe-to-data time can include: an edge strobe-to-data time range on at least one side of the strobe-to-data time range is determined; the first sub-step size of the edge strobe-to-data time range is set; a middle strobe-to-data time range in the strobe-to-data time range except for the edge strobe-to-data time range is determined; the second sub-step size of the middle strobe-to-data time range is set; and the edge strobe-to-data time range is scanned with the first sub-step size, and the middle strobe-to-data time range is scanned with the second sub-step size, to obtain each strobe-to-data time.

For an example, if each strobe-to-data time is taken as an abscissa value (first coordinate value), the strobe-to-data time range at a left side, or a right side, or both the left side and right side of the strobe-to-data time range can be taken as the edge strobe-to-data time range, the scanning is performed with the relatively great first sub-step size in the edge strobe-to-data time range to obtain each strobe-to-data time in the edge strobe-to-data time range, and the scanning is performed with the relatively small second sub-step size in the middle strobe-to-data time range except for the above edge strobe-to-data time range to obtain each strobe-to-data time in the middle strobe-to-data time range.

For another example, if each strobe-to-data time is taken as an ordinate value (first coordinate value), the strobe-to-data time range at an upper side, or a lower side, or both the upper side and lower side of the strobe-to-data time range can be taken as the edge strobe-to-data time range, the scanning is performed with the relatively great first sub-step size in the edge strobe-to-data time range to obtain each strobe-to-data time in the edge strobe-to-data time range, and the scanning is performed with the relatively small second sub-step size in the middle strobe-to-data time range except for the above edge strobe-to-data time range to obtain each strobe-to-data time in the middle strobe-to-data time range.

In the embodiment of the disclosure, on one hand, the scanning is performed with the relatively great first sub-step size to obtain each strobe-to-data time in the edge strobe-to-data time range, so that the number of the finally obtained total strobe-to-data time can be reduced, the occupied storage space is reduced, the computation amount is reduced, and the speed of obtaining target strobe-to-data time can be increased subsequently; and on the other hand, since the strobe-to-data time to be obtained subsequently through the data eye diagram is generally located in the middle of the strobe-to-data time range, the scanning is performed with the relatively small second sub-step to obtain each strobe-to-data time in the middle strobe-to-data time range, the precision of the obtained target strobe-to-data time can be improved.

It is to be noted that although in the following illustration, the scanning being performed with the unequal step sizes (the first sub-step size and the second sub-step size) to obtain each strobe-to-data time is taken as an example for illustration, the disclosure is not limited here. In other embodiments, the entire strobe-to-data time range may also be scanned with the equal step size to obtain each strobe-to-data time.

In the example embodiment, the interface circuit includes a first signal receiver. For example, assuming that one channel in the interface circuit can include 16 data signals (which can be respectively marked as DQO to DQ15, referred to as a first data signal to a sixteenth data signal), one byte group can include 8 data signals, for example, DQO to DQ7 in the same channel form one byte group, and DQ8 to DQ 15 form another byte group.

In the embodiment of the disclosure, the first signal receiver can be configured to receive the first data signal DQO in the data signals DQ, but the disclosure is not limited here. The first signal receiver can be configured to receive any data signal in the data signals DQ. The test result includes a first test result.

In the embodiment of the disclosure, the first signal receiver (which may also include a second signal receiver hereinafter) in the interface circuit may adopt the form of a single-ended signal.

With continued reference to FIG. 2, S130 in the above embodiment of FIG. 1 includes S131. In S131, the first test result of the first signal receiver under each strobe-to-data time and each reference voltage is obtained.

In the example embodiment, the operation that a data eye diagram is generated according to the test result can include: by taking each strobe-to-data time as a first coordinate value and taking each reference voltage as a second coordinate value, a two-dimensional data eye diagram displaying the test results is generated according to the test results under each strobe-to-data time and each reference voltage.

With continued reference to FIG. 2, S140 in the above embodiment of FIG. 1 includes S141. In S141, by taking each strobe-to-data time as a first coordinate value and taking each reference voltage as a second coordinate value, the data eye diagram of the first signal receiver is generated according to the first test result of the first signal receiver.

In the embodiment of the disclosure, after the first signal receiver in the interface circuit is selected, the first test result of the first signal receiver under each reference voltage and each strobe-to-data time is obtained to generate the data eye diagram of the first signal receiver. That is, according to the method provided by the embodiment of the disclosure, the data eye diagram of a single signal receiver can be obtained, the target strobe-to-data time and/or the target reference voltage of the single signal receiver can be located, meanwhile, an additional test bench is not needed, and the existing test bench is adopted.

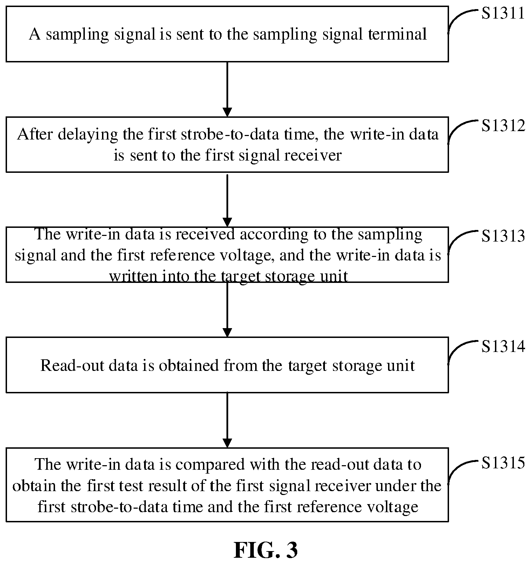

Specifically, for example, a test can be performed through the embodiment in FIG. 3 to obtain the first test result of the first signal receiver, but the disclosure is not limited here.

FIG. 3 schematically shows a processing flow diagram of S131 in FIG. 2 in an example embodiment. In the embodiment of the disclosure, the strobe-to-data time can include first strobe-to-data time, the reference voltage can include a first reference voltage, the interface circuit may further include a sampling signal terminal, and the data signal can include write-in data.

In S1311, a sampling signal is sent to the sampling signal terminal.

In S1312, after delaying the first strobe-to-data time, the write-in data is sent to the first signal receiver.

In S1313, the write-in data is received according to the sampling signal and the first reference voltage, and the write-in data is written into the target storage unit.

In S1314, read-out data is obtained from the target storage unit.

In S1315, the write-in data is compared with the read-out data to obtain the first test result of the first signal receiver under the first strobe-to-data time and the first reference voltage.

In the example embodiment, the operation that the write-in data is compared with the read-out data to obtain the first test result of the first signal receiver under the first strobe-to-data time and the first reference voltage can include: if the write-in data is equal to the read-out data, the first test result of the first signal under the first strobe-to-data time and the first reference voltage passes; and if the write-in data is not equal to the read-out data, the first test result of the first signal receiver under the first strobe-to-data time and the first reference voltage fails. It is to be noted that the embodiment may adapt to various test patterns, and a particular test pattern does not need to be specifically designed.

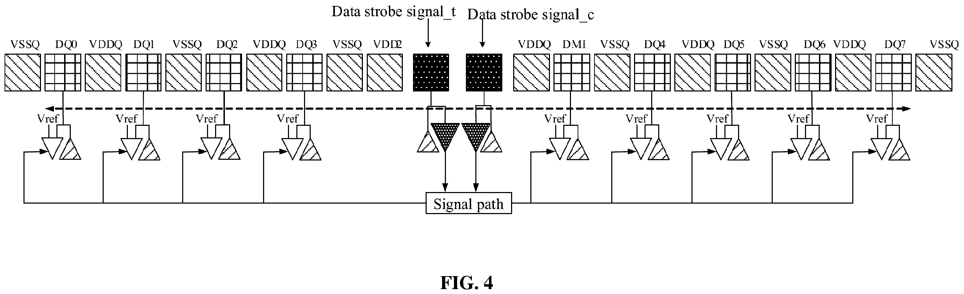

FIG. 4 schematically shows a schematic diagram of a semiconductor memory according to the present invention.

As shown in FIG. 4, the data strobe signal can include a data strobe signal_t and a data strobe signal_c which are inverted signals.

The LPDDR4 is taken as an example, the signal receiver corresponding to each data signal DQ is generally beside a DQ input port, and the data strobe signal DQS needs to be pulled from a data strobe signal DQS input port to the signal receiver corresponding to each DQ. Therefore, when performing a write operation, internal delay of the data strobe signal DQS in a receiving direction is greater than the internal delay of the data signal DQ, and such path mismatch may influence the accurate triggering of the write operation.

In order to improve the situation, the semiconductor memory requires a storage controller to compensate for delay difference between the data strobe signal DQS and the data signal DQ, and the data strobe signal DQS is sent earlier than the data signal DQ to ensure that the data strobe signal DQS and the data signal DQ can receive data accurately. Advanced sending time is defined in the JEDEC standard and is referred to as strobe-to-data time tDQS2DQ.

The data strobe signal DQS in the LPDDR4 is taken as an example for illustration, and the data strobe signal can include DQS_t and DQS_c which are inverted. In a training phase, a correct timing problem of the strobe-to-data time tDQS2DQ is solved through the write operation. Each strobe-to-data time tDQS2DQ is determined first, and then the data strobe signal DQS is input into the LPDDR4. Then the data strobe signal DQS is respectively input to the signal receiver (for example, the first signal receiver to the fifteenth signal receiver) corresponding to each DQ (for example, the DQO to the DQ15 in FIG. 4) through a clock path, as a clock trigger signal of each signal receiver. After the time tDQS2DQ, the corresponding data signal DQ is respectively input to each signal receiver, and then the read-out data is obtained from the storage unit of the LPDDR4 corresponding to each signal receiver. Whether the write-in data and the read-out data of the corresponding signal receiver are consistent is compared, if so, the test result of the corresponding signal receiver passes, and if not, the test result of the corresponding signal receiver fails.

VSSQ, VDDQ, and VDD2 in FIG. 4 respectively represent different power supply voltages in the semiconductor memory. DMI is an English abbreviation for Data Mask Inversion, that is, data mask inversion.

Since a chip of the semiconductor memory needs a packaging model and a channel model, a signal transmission path can be changed, and the test result can be influenced. Therefore, the test can be performed after the packaging model and the channel model are added and this is more similar to an actual application scenario, so that the result is more accurate.

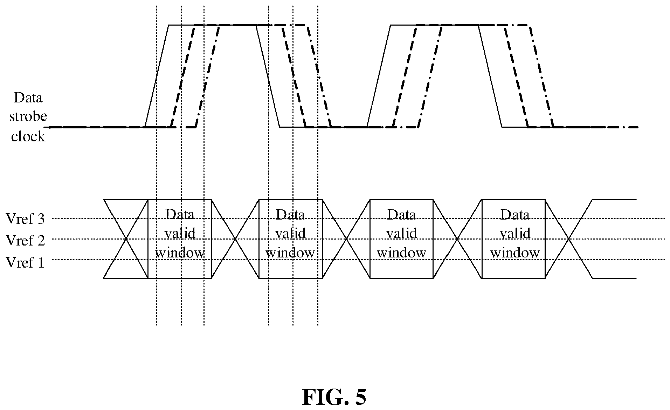

FIG. 5 schematically shows a schematic diagram of a data strobe signal and a data valid window under different reference voltages according to one embodiment of the disclosure.

As shown in FIG. 5, since the data signal is generally not perfectly square, but is wave-shaped, the rising and falling edges of the data strobe signal (for example, the DQS) for triggering sampling are preferably located just in the middle of a data valid window of a high-speed data signal, so that the high-speed data signal can be well captured.

In FIG. 5, three reference voltages Vref1, Vref2, and Vref3 are taken as an example for illustration, assuming that rising and falling edges of the data strobe signal deviate from the middle of the data valid window under the Vref1 and Vref3 reference voltages. Under the Vref2 reference voltage, if the rising and falling edges of the data strobe signal are located just in the middle of the data valid window, the Vref2 can be taken as the target reference voltage.

In the example embodiment, the method may further include: target strobe-to-data time and/or a target reference voltage is determined according to the data eye diagram.

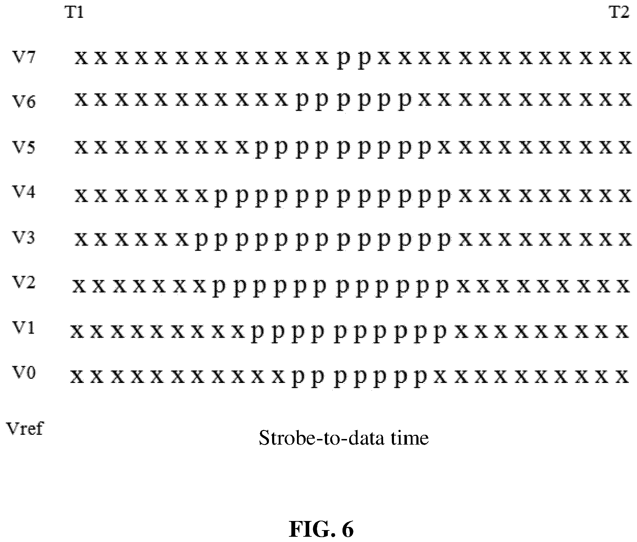

FIG. 6 schematically shows a schematic diagram of a data eye diagram according to one embodiment of the disclosure.

The LPDDR4 is still taken as an example, assuming that the reference voltage Vref is taken as the ordinate value and the strobe-to-data time tDQS2DQ is taken as the abscissa value, the data eye diagram shown in FIG. 6 is generated according to pass (p) and fail (X) in the test result.

For example, assuming that the strobe-to-data time range is [T1=0 ps, T2=800 ps], the strobe-to-data time range can be scanned by adopting the same step size (for example, 20 ps) to obtain each strobe-to-data time, the scanning may also be performed by adopting the relatively large first sub-step size in the edge strobe-to-data time range at the left side or the right side, or both the left side and the right side to obtain each strobe-to-data time in the edge strobe-to-data time range, and the scanning may also be performed by adopting the relatively small second sub-step in the middle strobe-to-data time range to obtain each strobe-to-data time in the middle strobe-to-data time range.

For example, assuming that the reference voltage range in FIG. 6 is [110 mV, 255 mV], the reference voltage range can be scanned by adopting the same step size to obtain each reference voltage, the scanning may also be performed by adopting the relatively large third sub-step size in the edge reference voltage range at the upper side or the lower side, or both the upper side and the lower side to obtain each reference voltage in the edge reference voltage range, and the scanning may also be performed by adopting the relatively small fourth sub-step in the middle reference voltage range to obtain each reference voltage in the middle reference voltage range.

Assuming that the third sub-step size is equal to 25 mv and the fourth sub-step size is equal to 20 mv, as an example, V0=110 mv, V1=135 mv, V2=155 mv, V3=175 mv, V4=195 mv, V5=215 mv, V6=235 mv, and V7=255 mv in FIG. 6.

According to the data eye diagram shown in FIG. 6, the reference voltage at a position where the data eye diagram "opens" maximally (a row and a column with the most p in an abscissa and an ordinate) can be taken as the target reference voltage, for example, V3 = 175 mv in FIG. 6, the strobe-to-data time can be taken as the target strobe-to-data time.

In the example embodiment, the interface circuit further includes the second signal receiver. The test result further includes a second test result.

In the embodiment of the disclosure, the second signal receiver can be any signal receiver. For example, the second signal receiver can be the second signal receiver corresponding to the second data signal DQ1, but the disclosure is not limited here.

The operation that a test result of the interface circuit under each reference voltage and each sampling point is obtained further includes: the second test result of the second signal receiver under each strobe-to-data time and each reference voltage is obtained. A procedure of obtaining the second test result may refer to the above description of obtaining the first test result.

The operation that a data eye diagram is generated according to the test result further includes: by taking each strobe-to-data time as a first coordinate value and taking each reference voltage as a second coordinate value, the data eye diagram of the second signal receiver is generated according to the second test result of the second signal receiver. The mode of generating the data eye diagram of the second signal receiver may refer to the above mode of generating the data eye diagram of the first signal receiver.

In the example embodiment, the method may further include: the data eye diagram of the first signal receiver is compared with the data eye diagram of the second signal receiver and offset between the first signal receiver and the second signal receiver is determined. The first signal receiver and the second signal receiver can be located in the same byte group.

For example, assuming that the first signal receiver corresponds to the first data signal DQO and the second signal receiver corresponds to the second data signal DQ1, the first signal receiver and the second signal receiver are located in the same byte group (DQ0 to DQ7), but the disclosure is not limited here. The offset between any two adjacent DQs in the byte group can be obtained by comparing the data eye diagram of each DQ.

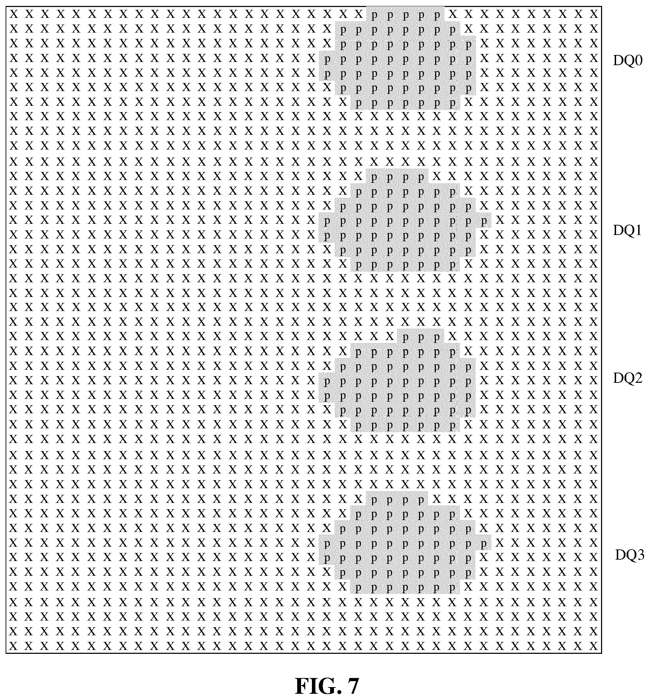

FIG. 7 schematically shows a schematic diagram of a data eye diagram according to one embodiment of the disclosure.

For example, as shown in FIG. 7, DQ0, DQ1, DQ2, and DQ3 in the byte group are taken as an example. Through adoption of the method provided by the embodiment of the disclosure, the data eye diagram of each DQ can be independently displayed, so that the offset between the two adjacent DQs can be compared, and which DQ is problematic can be located, thereby modifying the design of the DQ.

Similarly, the data eye diagram of one signal receiver corresponding to any of DQ4 to DQ15, and the offset therebetween can be obtained.

In the present invention, the method further includes: a composite eye diagram of the interface circuit is generated according to the data eye diagram of the first signal receiver and the data eye diagram of the second signal receiver.

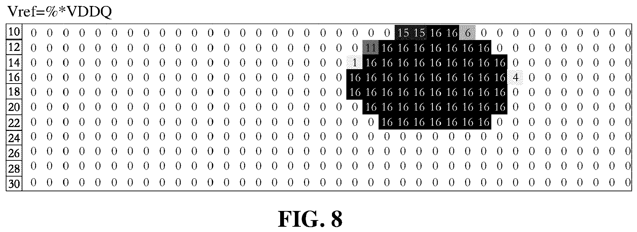

As shown in FIG. 8, it is assumed that VDDQ=1.1 V. The data eye diagrams of 16 DQs (DQ0 to DQ15) as shown in FIG. 7 are obtained first, 'p' in each data eye diagram is represented by '1', and 'X' is represented by '0', and then the test results at corresponding positions of the 16 data eye diagrams are superposed to obtain the composite eye diagram of the interface circuit as shown in FIG. 8. If a value at a certain position is 16, this represents that the test results of the DQO to DQ15 under the corresponding reference voltage and the corresponding strobe-to-data time pass. If a value at a certain position is 15, this represents that the test results of 15 DQs in the DQO to DQ15 under the corresponding reference voltage and the corresponding strobe-to-data time pass, and the test result of one DQ fails. If a value at a certain position is 11, this represents that the test results of 11 DQs in the DQO to DQ15 under the corresponding reference voltage and the corresponding strobe-to-data time pass, and the test result of 5 DQ fail. If a value at a certain position is 6, this represents that the test results of 6 DQs in the DQO to DQ15 under the corresponding reference voltage and the corresponding strobe-to-data time pass, and the test result of 10 DQ fail. If a value at a certain position is 4, this represents that the test results of 4 DQs in the DQO to DQ15 under the corresponding reference voltage and the corresponding strobe-to-data time pass, and the test result of 12 DQs fail. If a value at a certain position is 1, this represents that the test result of 1 DQ in the DQO to DQ15 under the corresponding reference voltage and the corresponding strobe-to-data time passes, and the test results of 15 DQs fail. If a value at a certain position is 0, this represents that the test results of 16 DQs in the DQO to DQ15 under the corresponding reference voltage and the corresponding strobe-to-data time fail.

The center of the composite eye diagram is taken as default target strobe-to-data time, and under the target strobe-to-data time, all DQ tests pass. If the area of the zero-free region of the composite eye diagram is large, this represents that the performance of the interface circuit is better and the semiconductor memory can work normally in a relatively large fluctuation range.

In the example embodiment, the operation that the data eye diagram of the first signal receiver is generated can include: the data eye diagram of the first signal receiver under a first process corner is obtained; and the data eye diagram of the first signal receiver under a second process corner is obtained.

In the example embodiment, the method may further include: the composite eye diagram of the first signal receiver is generated according to the data eye diagram of the first signal receiver under the first process corner and the data eye diagram of the first signal receiver under the second process corner. The influence of different process corners on the interface circuit can be obtained by checking the composite eye diagrams under different process corners.

By testing the data eye diagrams of the first signal receiver at different temperatures, how the performance of the first signal receiver is can be visually displayed, for example, if the overlapping area of the "p" regions at 85°C and 25°C is large, this represents that the same target strobe-to-data time and target reference voltage can be set to the first signal receiver in the temperature range [25°C, 85°C]. For another example, although the overlapping area of the "p" regions of the two data eye diagrams is not large, the large area of the "p" regions of the two data eye diagrams represents that the working performance of the first signal receiver at different temperatures is better.

In the example embodiment, the composite eye diagram of the interface circuit under the first process corner and the composite eye diagram of the interface circuit under the second process corner can be obtained.

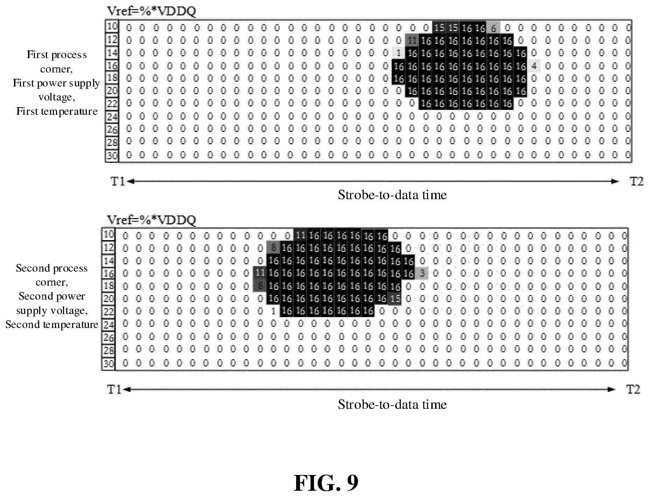

For example, as shown in FIG. 9, the performance of the interface circuit can be influenced by power, voltage, and temperature. Assuming that the first process corner is SS, a first power supply voltage is 1 V, and the first temperature is 85°C, the composite eye diagram of the interface circuit under the first process corner, the first power supply voltage, and the first temperature can be obtained.

Assuming that the second process corner is TT, a second supply voltage is 1 V, and the second temperature is 25°C, the composite eye diagram of the interface circuit under the second process corner, the second power supply voltage, and the second temperature can be obtained.

By testing the composite eye diagrams of the interface circuit at different temperatures, how the performance of the interface circuit is can be visually displayed, for example, if the overlapping area of the zero-free regions at 85°C and 25°C is large, this represents that the same target strobe-to-data time and target reference voltage can be set to the interface circuit in the temperature range [25°C, 85°C]. As another example, although the overlapping area of the zero-free regions of the two composite eye diagrams is not large, the area of the zero-free regions of the two composite eye diagrams is large, this represents that the working performance of the interface circuit is better at different temperatures.

Through the method provided by the embodiment of the disclosure, a relationship between simulation and an actual test result of the chip of the semiconductor memory can be obtained, for example, some samples are manufactured, the samples are tested, the difference between the simulated test result and the test result of the sample is compared, an error between the simulation and the test result is eliminated, and the subsequently simulated test result is more accurate.

An apparatus embodiment of the disclosure is described below and can be configured to execute the above method for evaluating performance of an interface circuit of the disclosure. For details not disclosed in the apparatus embodiment of the disclosure, reference is made to the embodiment of the above method for evaluating performance of an interface circuit of the disclosure.

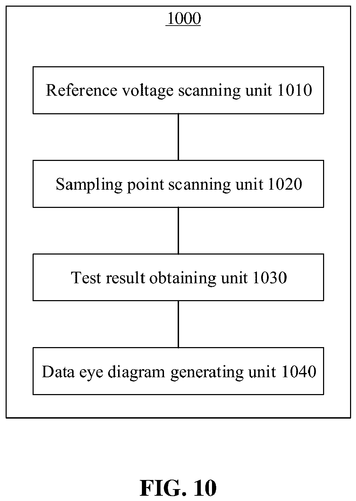

FIG. 10 schematically shows a block diagram of an apparatus for evaluating performance of an interface circuit according to one embodiment of the disclosure. The interface circuit can be configured to receive a data signal according to a data strobe signal.

Referring to FIG. 10, the apparatus 1000 for evaluating performance of a memory interface circuit according to the present invention includes a reference voltage scanning unit 1010, a sampling point scanning unit 1020, a test result obtaining unit 1030, and a data eye diagram generating unit 1040.

The reference voltage scanning unit 1010 can be configured to scan a reference voltage of the interface circuit to obtain each reference voltage. The sampling point scanning unit 1020 can be configured to scan a sampling point of the data strobe signal to the data signal. The test result obtaining unit 1030 can be configured to obtain a test result of the interface circuit under each reference voltage and each sampling point. The data eye diagram generating unit 1040 can be configured to generate a data eye diagram according to the test result.

In the example embodiment, the sampling point scanning unit 1020 includes a strobe-to-data time obtaining unit which is configured to scan a strobe-to-data time range of the interface circuit with a first step size to obtain each strobe-to-data time.

In the example embodiment, the first step size can include a first sub-step size and a second sub-step size.

The strobe-to-data time obtaining unit can include an edge strobe-to-data time range determining unit which can be configured to determine an edge strobe-to-data time range on at least one side of the strobe-to-data time range; a first sub-step size setting unit which can be configured to set the first sub-step size of the edge strobe-to-data time range; a middle strobe-to-data time range setting unit which can be configured to set a middle strobe-to-data time range in the strobe-to-data time range except for the edge strobe-to-data time range; a second sub-step size setting unit which can be configured to set the second sub-step size of the middle strobe-to-data time range; and a strobe-to-data time unit is obtained through scanning, which can be used in scanning the edge strobe-to-data time range with the first sub-step size, and the middle strobe-to-data time range can be scanned with the second sub-step size, to obtain each strobe-to-data time.

The first sub-step size can be greater than the second sub-step size.

In the example embodiment, the reference voltage scanning unit 1010 includes a reference voltage obtaining unit, which is configured to scan the reference voltage range of the interface circuit with a second step size, to obtain each reference voltage.

In the example embodiment, the second step size can include a third sub-step size and a fourth sub-step size. The reference voltage obtaining unit can include: an edge reference voltage range determining unit, which can be configured to determine an edge reference voltage range on at least one side of the reference voltage range; a third sub-step size setting unit which can be configured to set the third sub-step size of the edge reference voltage range; a middle reference voltage range determining unit which can be configured to determine a middle reference voltage range except for the edge reference voltage range in the reference voltage range; a fourth sub-step size setting unit which can be configured to set the fourth sub-step size of the middle reference voltage range; and a reference voltage scan-to-obtain unit which can be configured to scan the edge reference voltage range with the third sub-step size, and scan the middle reference voltage range with the fourth sub-step size, to obtain each reference voltage.

The third sub-step size can be greater than the fourth sub-step size.

In the example embodiment, the data eye diagram generating unit 1040 can include: a two-dimensional data eye diagram generating unit which can be configured to, by taking each strobe-to-data time as a first coordinate value and taking each reference voltage as a second coordinate value, generate a two-dimensional data eye diagram displaying the test results according to the test results under each strobe-to-data time and each reference voltage.

In the example embodiment, the interface circuit includes a first signal receiver. The test result includes a first test result.

The test result obtaining unit 1030 includes: a first test result obtaining unit which is configured to obtain the first test result of the first signal receiver under each strobe-to-data time and each reference voltage.

The data eye diagram generating unit 1040 includes: a first signal receiver data eye diagram generating unit which is configured to, by taking each strobe-to-data time as a first coordinate value and taking each reference voltage as a second coordinate value, generate the data eye diagram of the first signal receiver according to the first test result of the first signal receiver.

In the example embodiment, the interface circuit further includes the second signal receiver. The test result further includes a second test result.

The test result obtaining unit 1030 further includes: a second test result obtaining unit which is configured to obtain the second test result of the second signal receiver under each strobe-to-data time and each reference voltage.

The data eye diagram generating unit 1040 further includes: a second signal receiver data eye diagram generating unit which is configured to, by taking each strobe-to-data time as a first coordinate value and taking each reference voltage as a second coordinate value, generate the data eye diagram of the second signal receiver according to the second test result of the second signal receiver.

In the example embodiment, the apparatus 1000 for evaluating performance of an interface circuit further includes: an interface circuit composite eye diagram unit which is configured to generate a composite eye diagram of the interface circuit according to the data eye diagram of the first signal receiver and the data eye diagram of the second signal receiver.

In the example embodiment, the first signal receiver data eye diagram generating unit can include: a first process corner data eye diagram generating unit which can be configured to obtain the data eye diagram of the first signal receiver under a first process corner; and a second process corner data eye diagram generating unit which can be configured to obtain the data eye diagram of the first signal receiver under a second process corner.

The apparatus 1000 for evaluating performance of an interface circuit may further include: a first signal receiver composite eye diagram generating unit which can be configured to generate the composite eye diagram of the first signal receiver according to the data eye diagram of the first signal receiver under the first process corner and the data eye diagram of the first signal receiver under the second process corner.

In the example embodiment, the apparatus 1000 for evaluating performance of an interface circuit may further include: a data eye diagram comparing unit which can be configured to compare the data eye diagram of the first signal receiver with the data eye diagram of the second signal receiver and determine offset between the first signal receiver and the second signal receiver.

The first signal receiver and the second signal receiver can be located in the same byte group.

In the example embodiment, the first signal receiver may correspond to a target storage unit in a semiconductor memory, the strobe-to-data time can include first strobe-to-data time, the reference voltage can include a first reference voltage, the interface circuit may further include a sampling signal terminal, and the data signal can include write-in data.

The first test result obtaining unit can include: a sampling signal sending unit which can be configured to send a sampling signal to the sampling signal terminal; a write-in data sending unit which can be configured to, after delaying the first strobe-to-data time, send write-in data to the first signal receiver; a write-in data write-in unit which can be configured to receive the write-in data according to the sampling signal and the first reference voltage and write the write-in data into the target storage unit; a read-out data obtaining unit which can be configured to obtain read-out data from the target storage unit; and a first test result obtaining unit which can be configured to compare the write-in data with the read-out data to obtain the first test result of the first signal receiver under the first strobe-to-data time and the first reference voltage.

In the example embodiment, the first test result obtaining unit can include: a first comparing unit which can be configured to, if the write-in data is equal to the read-out data, indicate that the first test result of the first signal under the first strobe-to-data time and the first reference voltage passes; and a second comparing unit which can be configured to, if the write-in data is not equal to the read-out data, indicate that the first test result of the first signal receiver under the first strobe-to-data time and the first reference voltage fails.

In the example embodiment, the apparatus 1000 for evaluating performance of an interface circuit may further include: a target strobe-to-data time determining unit and/or a target reference voltage determining unit.

The target strobe-to-data time determining unit can be configured to determine target strobe-to-data time according to the data eye diagram. The target reference voltage determining unit can be configured to determine a target reference voltage according to the data eye diagram.

It is to be noted that although in the above detailed description, reference has been made to a number of units of a device for action execution, such division is not mandatory. Indeed, according to the embodiment of the disclosure, the features and functions of two or more units described above can be embodied in one unit. On the contrary, the features and functions of one unit described above may further be divided to be embodied by a plurality of units.

From the above description of the implementation mode, those skilled in the art are easy to understand that the example implementation mode described here can be implemented through software or may also be implemented through the software in combination with necessary hardware. Therefore, the technical solution according to the embodiment of the disclosure can be embodied in the form of a software product. The software product can be stored in a non-volatile storage medium (which can be a CD-ROM, a U-disk, a mobile hard disk, and the like) or on a network, and can include a number of instructions, so that a computing device (which can be a personal computer, a server, a touch terminal, or a network device, and the like) executes the method according to the embodiment of the disclosure.

Further, an implementation mode of the disclosure further provides an electronic device, including: at least one processor; and a storage device, configured to store at least one program. When the at least one program is executed by the at least one processor, the at least one processor is enabled to implement the method in any above embodiment.

Further, an implementation mode of the disclosure further provides a computer-readable storage medium having a computer program stored thereon. When the program is executed by a processor, the method in any above embodiment provided by the disclosure is implemented.

Other embodiments of the disclosure will be apparent to those skilled in the art from consideration of the specification and practice of the disclosure disclosed here. The present application is intended to cover any variations, uses, or adaptations of the disclosure, and the variations, uses, or adaptations follow the general principles of the disclosure and include common general knowledge or conventional technical means in the art undisclosed by the disclosure. The specification and embodiments are considered as examples only, and the scope of the disclosure are indicated by the appended claims.

## Claims

1. A method for evaluating performance of a memory interface circuit, the memory interface circuit being configured to receive a data signal, DQ, according to a data strobe signal, the method comprises:
scanning a reference voltage of the memory interface circuit to obtain each reference voltage (S110);
scanning sampling points of the DQ by the data strobe signal (S120);
obtaining a test result of the memory interface circuit at each reference voltage and each sampling point (S130); and
generating a data eye diagram according to the test result (S140);
wherein the scanning sampling points of the DQ by the data strobe signal (S120) comprises:
scanning a strobe-to-data time range of the memory interface circuit with a first step size to obtain each strobe-to-data time (S121), wherein strobe-to-data time represents the time difference between the data strobe signal and the DQ;
wherein the scanning a reference voltage of the memory interface circuit to obtain each reference voltage (S 110) comprises:
scanning a reference voltage range of the memory interface circuit with a second step size to obtain each reference voltage;
wherein the memory interface circuit comprises a first signal receiver, and the test result comprises a first test result, wherein the obtaining a test result of the memory interface circuit under each reference voltage and each sampling point comprises:
obtaining the first test result of the first signal receiver under each strobe-to-data time and each reference voltage (S131); and
generating a data eye diagram according to the test result comprising:
by taking each strobe-to-data time as a first coordinate value and taking each reference voltage as a second coordinate value, generating the data eye diagram of the first signal receiver according to the first test result of the first signal receiver (S141);
**characterised in that** the memory interface circuit comprises a second signal receiver, and the test result comprises a second test result, wherein the obtaining a test result of the memory interface circuit under each reference voltage and each sampling point further comprises:
obtaining the second test result of the second signal receiver under each strobe-to-data time and each reference voltage; and
generating a data eye diagram according to the test result further comprising:
by taking each strobe-to-data time as a first coordinate value and taking each reference voltage as a second coordinate value, generating the data eye diagram of the second signal receiver according to the second test result of the second signal receiver;
wherein the method further comprises:
generating a composite eye diagram of the memory interface circuit according to the data eye diagram of the first signal receiver and the data eye diagram of the second signal receiver, a center of the composite eye diagram being default target strobe-to-data time, such that under the target strobe-to-data time, all DQs pass a test.

2. The method of claim 1, wherein the first step size comprises a first sub-step size and a second sub-step size, wherein the scanning a strobe-to-data time range of the memory interface circuit with a first step size to obtain each strobe-to-data time comprises:
determining an edge strobe-to-data time range of at least one side of the strobe-to-data time range;
setting the first sub-step size of the edge strobe-to-data time range;
setting a middle strobe-to-data time range in the strobe-to-data time range except for the edge strobe-to-data time range;
setting the second sub-step size of the middle strobe-to-data time range; and
scanning the edge strobe-to-data time range with the first sub-step size, and scanning the middle strobe-to-data time range with the second sub-step size, to obtain each strobe-to-data time,
wherein the first sub-step size is greater than the second sub-step size.

3. The method of claim 1, wherein the second step size comprises a third sub-step size and a fourth sub-step size, wherein the scanning a reference voltage range of the memory interface circuit with a second step size to obtain each reference voltage comprises:
determining an edge reference voltage range on at least one side of the reference voltage range;
setting the third sub-step size of the edge reference voltage range;
determining a middle reference voltage range in the reference voltage range except for the edge reference voltage range;
setting the fourth sub-step size of the middle reference voltage range; and
scanning the edge reference voltage range with the third sub-step size, and scanning the middle reference voltage range with the fourth sub-step size, to obtain each reference voltage,
wherein the third sub-step size is greater than the fourth sub-step size.

4. The method of claim 1, wherein generating a data eye diagram according to the test result comprises:
using each strobe-to-data time as a first coordinate value and using each reference voltage as a second coordinate value, generating a two-dimensional data eye diagram displaying the test results according to the test results under each strobe-to-data time and each reference voltage.

5. The method of claim 1, wherein the generating the data eye diagram of the first signal receiver comprises:
obtaining the data eye diagram of the first signal receiver under a first process corner; and
obtaining the data eye diagram of the first signal receiver under a second process corner,
wherein the method further comprises:
generating the composite eye diagram of the first signal receiver according to the data eye diagram of the first signal receiver under the first process corner and the data eye diagram of the first signal receiver under the second process corner.

6. The method of claim 1, further comprising:
comparing the data eye diagram of the first signal receiver with the data eye diagram of the second signal receiver and determining offset between the first signal receiver and the second signal receiver, wherein the first signal receiver and the second signal receiver are located in a same byte group.

7. The method of claim 1, wherein the first signal receiver corresponds to a target storage unit in a semiconductor memory, the strobe-to-data time comprises first strobe-to-data time, the reference voltage comprises a first reference voltage, the memory interface circuit further comprises a sampling signal terminal, and the data signal comprises write-in data, wherein the obtaining the first test result of the first signal receiver under each strobe-to-data time and each reference voltage comprises:
sending a sampling signal to the sampling signal terminal (S1311);
after delaying the first strobe-to-data time, sending the write-in data to the first signal receiver (S1312);
receiving the write-in data according to the sampling signal and the first reference voltage and writing the write-in data into the target storage unit (S1313);
obtaining read-out data from the target storage unit (S1314); and
comparing the write-in data with the read-out data to obtain the first test result of the first signal receiver under the first strobe-to-data time and the first reference voltage (S1315).

8. The method of claim 7, wherein the comparing the write-in data with the read-out data to obtain the first test result of the first signal receiver under the first strobe-to-data time and the first reference voltage comprises:
if the write-in data is equal to the read-out data, the first test result of the first signal under the first strobe-to-data time and the first reference voltage is a pass; and
if the write-in data is not equal to the read-out data, the first test result of the first signal receiver under the first strobe-to-data time and the first reference voltage is a fail.

9. An apparatus for evaluating performance of a memory interface circuit, the memory interface circuit being configured to receive a data, DQ, signal according to a data strobe signal, the apparatus comprising:
a reference voltage scanning unit (1010), configured to scan a reference voltage of the memory interface circuit to obtain each reference voltage;
a sampling point scanning unit (1020), configured to scan a sampling point of the data strobe signal to the data signal;
a test result obtaining unit (1030), configured to obtain a test result of the memory interface circuit under each reference voltage and each sampling point; and
a data eye diagram generating unit (1040), configured to generate a data eye diagram according to the test result
wherein:
the sampling point scanning unit (1020) comprises a strobe-to-data time obtaining unit, configured to scan a strobe-to-data time range of the memory interface circuit with a first step size to obtain each strobe-to-data time, wherein strobe-to-data time represents the time difference between the data strobe signal and the DQ;
the reference voltage scanning unit (1010) comprises a reference voltage obtaining unit, configured to scan a reference voltage range of the memory interface circuit with a second step size to obtain each reference voltage;
the memory interface circuit comprises a first signal receiver, and the test result comprises a first test result;
the test result obtaining unit (1030) comprises: a first test result obtaining unit, configured to obtain the first test result of the first signal receiver under each strobe-to-data time and each reference voltage;
the data eye diagram generating unit (1040) comprises: a first signal receiver data eye diagram generating unit, configured to, by taking each strobe-to-data time as a first coordinate value and taking each reference voltage as a second coordinate value, generate the data eye diagram of the first signal receiver according to the first test result of the first signal receiver;
**characterised in that** the memory interface circuit comprises a second signal receiver, and the test result comprises a second test result;
the test result obtaining unit (1030) further comprises: a second test result obtaining unit, configured to obtain the second test result of the second signal receiver under each strobe-to-data time and each reference voltage;
the data eye diagram generating unit (1040) further comprises: a second signal receiver data eye diagram generating unit, configured to, by taking each strobe-to-data time as a first coordinate value and taking each reference voltage as a second coordinate value, generate the data eye diagram of the second signal receiver according to the second test result of the second signal receiver;
the apparatus for evaluating performance of the memory interface circuit further comprises: an interface circuit composite eye diagram unit, configured to generate a composite eye diagram of the memory interface circuit according to the data eye diagram of the first signal receiver and the data eye diagram of the second signal receiver, a center of the composite eye diagram being default target strobe-to-data time, such that under the target strobe-to-data time, all DQs pass a test.

10. A computer-readable storage medium having a computer program stored thereon, wherein responsive to that the program is executed by a processor, the method according to any one of claims 1-8 is implemented.

## Patentansprüche

1. Verfahren zur Bewertung der Leistung einer Speicherschnittstellenschaltung, wobei die Speicherschnittstellenschaltung so konfiguriert ist, dass sie ein Datensignal DQ entsprechend einem Daten-Strobe-Signal empfängt, wobei das Verfahren Folgendes umfasst:
Abtasten einer Referenzspannung der Speicherschnittstellenschaltung, um jede Referenzspannung (S110) zu erhalten;
Abtasten von Abtastpunkten des DQ durch das Daten-Strobe-Signal (S120);
Erhalten eines Testergebnisses der Speicherschnittstellenschaltung bei jeder Referenzspannung und an jedem Abtastpunkt (S130); und
Erstellung eines Daten-Augendiagramms entsprechend dem Testergebnis (S140);
wobei die Abtastung von Abtastpunkten des DQ durch das Daten-Strobe-Signal (S120) umfasst:
Abtasten eines Strobe-to-Data-Zeitbereichs der Speicherschnittstellenschaltung mit einer ersten Schrittgröße, um jede Strobe-to-Data-Zeit zu erhalten (S121), wobei die Strobe-to-Data-Zeit die Zeitdifferenz zwischen Daten-Strobe-Signal und DQ darstellt;
wobei das Abtasten einer Referenzspannung der Speicherschnittstellenschaltung zum Erhalten jeder Referenzspannung (S110) umfasst:
Abtasten eines Referenzspannungsbereichs der Speicherschnittstellenschaltung mit einer zweiten Schrittweite, um jede Referenzspannung zu erhalten;
wobei die Speicherschnittstellenschaltung einen ersten Signalempfänger umfasst, und das Testergebnis ein erstes Testergebnis umfasst, wobei das Erhalten eines Testergebnisses der Speicherschnittstellenschaltung unter jeder Referenzspannung und jedem Abtastpunkt umfasst:
Ermitteln des ersten Testergebnisses des ersten Signalempfängers bei jeder Strobe-to-Data-Zeit und jeder Referenzspannung (S131); und
Erzeugung eines Daten-Augendiagramms entsprechend dem Testergebnis, das Folgendes umfasst:
Erzeugen des Daten-Augendiagramms des ersten Signalempfängers entsprechend dem ersten Testergebnis des ersten Signalempfängers (S141), indem jede Strobe-to-Data-Zeit als ein erster Koordinatenwert und jede Referenzspannung als ein zweiter Koordinatenwert genommen wird;
**dadurch gekennzeichnet, dass** die Speicherschnittstellenschaltung einen zweiten Signalempfänger umfasst, und das Testergebnis ein zweites Testergebnis umfasst, wobei das Erhalten eines Testergebnisses der Speicherschnittstellenschaltung unter jeder Referenzspannung und jedem Abtastpunkt weiterhin umfasst:
Ermitteln des zweiten Testergebnisses des zweiten Signalempfängers bei jeder Strobe-to-Data-Zeit und jeder Referenzspannung; und
Erzeugen eines Daten-Augendiagramms entsprechend dem Testergebnis, das ferner Folgendes umfasst:
Erzeugen des Daten-Augendiagramms des zweiten Signalempfängers gemäß dem zweiten Testergebnis des zweiten Signalempfängers, indem jede Strobe-to-Data-Zeit als ein erster Koordinatenwert genommen wird und jede Referenzspannung als ein zweiter Koordinatenwert genommen wird; wobei das Verfahren ferner umfasst:
Erzeugen eines zusammengesetzten Augendiagramms der Speicherschnittstellenschaltung gemäß dem Daten-Augendiagramm des ersten Signalempfängers und dem Daten-Augendiagramm des zweiten Signalempfängers, wobei ein Zentrum des zusammengesetzten Augendiagramms eine Standard-Ziel-Strobe-to-Data-Zeit ist, so dass unter der Ziel-Strobe-to-Data-Zeit alle DQs einen Test bestehen.

2. Verfahren nach Anspruch 1, wobei die erste Schrittgröße eine erste Teilschrittgröße und eine zweite Teilschrittgröße umfasst, wobei das Abtasten eines Strobe-to-Data-Zeitbereichs der Speicherschnittstellenschaltung mit einer ersten Schrittgröße zum Erhalten jeder Strobe-to-Data-Zeit umfasst:
Bestimmung eines Zeitbereichs zwischen Flankenstrobe und Daten auf mindestens einer Seite des Strobe-to-Data-Zeitbereichs;
Einstellung der ersten Teilschrittgröße des Zeitbereichs zwischen Flankenstrobe und Daten;
Einstellung eines mittleren Strobe-to-Data-Zeitbereichs im Strobe-to-Data-Zeitbereich mit Ausnahme des Zeitbereichs zwischen Flankenstrobe und Daten;
Einstellen der zweiten Teilschrittgröße des mittleren Strobe-to-Data-Zeitbereichs; und
Abtasten des Zeitbereichs zwischen Flankenstrobe und Daten mit der ersten Teilschrittgröße, und Abtasten des mittleren Strobe-to-Data-Zeitbereichs mit der zweiten Teilschrittgröße, um jede Strobe-to-Data-Zeit zu erhalten,
wobei die erste Teilschrittgröße größer ist als die zweite Teilschrittgröße.

3. Verfahren nach Anspruch 1, wobei die zweite Schrittgröße eine dritte Teilschrittgröße und eine vierte Teilschrittgröße umfasst, wobei das Abtasten eines Referenzspannungsbereiches der Speicherschnittstellenschaltung mit einer zweiten Schrittgröße zum Erhalten jeder Referenzspannung umfasst:
Bestimmung eines Rand-Referenzspannungsbereichs auf mindestens einer Seite des Referenzspannungsbereichs;
Einstellung der dritten Teilschrittgröße des Rand-Referenzspannungsbereichs;
Bestimmung eines mittleren Referenzspannungsbereiches im Referenzspannungsbereich mit Ausnahme des Rand-Referenzspannungsbereiches;
Einstellen der vierten Teilschrittgröße des mittleren Referenzspannungsbereiches; und
Abtasten des Rand-Referenzspannungsbereichs mit der dritten Teilschrittgröße und Abtasten des mittleren Referenzspannungsbereichs mit der vierten Teilschrittgröße, um jede Referenzspannung zu erhalten,
wobei die dritte Teilschrittgröße größer ist als die vierte Teilschrittgröße.

4. Verfahren nach Anspruch 1, wobei das Erzeugen eines Daten-Augendiagramms entsprechend dem Testergebnis umfasst:
Erzeugen eines zweidimensionalen Daten-Augendiagramms, das die Testergebnisse entsprechend den Testergebnissen unter jeder Strobe-to-Data-Zeit und jeder Referenzspannung anzeigt, wobei jede Strobe-to-Data-Zeit als ein erster Koordinatenwert und jede Referenzspannung als ein zweiter Koordinatenwert verwendet wird.

5. Verfahren nach Anspruch 1, wobei das Erzeugen des Daten-Augendiagramms des ersten Signalempfängers umfasst:
Erhalten des Daten-Augendiagramms des ersten Signalempfängers unter einer ersten Prozessecke; und
Erhalten des Daten-Augendiagramms des ersten Signalempfängers unter einer zweiten Prozessecke,
wobei das Verfahren ferner Folgendes umfasst:
Erzeugen des zusammengesetzten Augendiagramms des ersten Signalempfängers entsprechend dem Daten-Augendiagramm des ersten Signalempfängers unter der ersten Prozessecke und dem Daten-Augendiagramm des ersten Signalempfängers unter der zweiten Prozessecke.

6. Verfahren nach Anspruch 1, ferner umfassend:
Vergleichen des Daten-Augendiagramms des ersten Signalempfängers mit dem Datenaugendiagramm des zweiten Signalempfängers und Bestimmen des Versatzes zwischen dem ersten Signalempfänger und dem zweiten Signalempfänger, wobei sich der erste Signalempfänger und der zweite Signalempfänger in derselben Bytegruppe befinden.

7. Verfahren nach Anspruch 1, wobei der erste Signalempfänger einer Zielspeichereinheit in einem Halbleiterspeicher entspricht, die Strobe-to-Data-Zeit eine erste Strobe-to-Data-Zeit umfasst, die Referenzspannung eine erste Referenzspannung umfasst, die Speicherschnittstellenschaltung ferner einen Abtastsignalanschluss umfasst und das Datensignal Einschreibedaten umfasst, wobei das Erhalten des ersten Testergebnisses des ersten Signalempfängers unter jeder Strobe-to-Data-Zeit und jeder Referenzspannung umfasst:
Senden eines Abtastsignals an den Abtastsignalanschluss (S1311);
nach der Verzögerung der ersten Strobe-to-Data-Zeit, Senden der Einschreibdaten an den ersten Signalempfänger (S1312);
Empfangen der Einschreibdaten entsprechend dem Abtastsignal und der ersten Referenzspannung und Schreiben der Einschreibdaten in die Zielspeichereinheit (S1313);
Erhalten von Auslesedaten aus der Zielspeichereinheit (S1314); und
Vergleichen der Einschreibdaten mit den Auslesedaten, um das erste Testergebnis des ersten Signalempfängers unter der ersten Strobe-to-Data-Zeit und der ersten Referenzspannung zu erhalten (S1315).

8. Verfahren nach Anspruch 7, wobei das Vergleichen der Einschreibdaten mit den Auslesedaten zum Erhalten des ersten Testergebnisses des ersten Signalempfängers unter der ersten Strobe-to-Data-Zeit und der ersten Referenzspannung umfasst:
wenn die Einschreibdaten gleich den Auslesedaten sind, ist das erste Testergebnis des ersten Signals unter der ersten Strobe-to-Data-Zeit und der ersten Referenzspannung ein Durchgang; und
wenn die Einschreibdaten nicht gleich den Auslesedaten sind, ist das erste Testergebnis des ersten Signalempfängers unter der ersten Strobe-to-Data-Zeit und der ersten Referenzspannung ein Fehlschlag.

9. Vorrichtung zur Bewertung der Leistung einer Speicherschnittstellenschaltung, wobei die Speicherschnittstellenschaltung so konfiguriert ist, dass sie ein Daten-, DQ-, Signal gemäß einem Daten-Strobe-Signal empfängt, wobei die Vorrichtung umfasst:
eine Referenzspannungsabtasteinheit (1010), die so konfiguriert ist, dass sie eine Referenzspannung der Speicherschnittstellenschaltung abtastet, um jede Referenzspannung zu erhalten;
eine Abtastpunkt-Abtasteinheit (1020), die so konfiguriert ist, dass sie einen Abtastpunkt des Daten-Strobe-Signals mit dem Datensignal abtastet;
eine Testergebnis-Ermittlungseinheit (1030), die so konfiguriert ist, dass sie ein Testergebnis der Speicherschnittstellenschaltung unter jeder Referenzspannung und jedem Abtastpunkt ermittelt; und
eine Daten-Augendiagramm-Erzeugungseinheit (1040), die so konfiguriert ist, dass sie ein Daten-Augendiagramm entsprechend dem Testergebnis erzeugt,
wobei:
die Abtastpunkt-Abtasteinheit (1020) eine Strobe-to-Data-Zeit-Ermittlungseinheit umfasst, die so konfiguriert ist, dass sie einen Strobe-to-Data-Zeitbereich der Speicherschnittstellenschaltung mit einer ersten Schrittgröße abtastet, um jede Strobe-to-Data-Zeit zu erhalten, wobei die Strobe-to-Data-Zeit die Zeitdifferenz zwischen dem Daten-Strobe-Signal und dem DQ darstellt;
die Referenzspannungsabtasteinheit (1010) eine Referenzspannungsermittlungseinheit umfasst, die konfiguriert ist, um einen Referenzspannungsbereich der Speicherschnittstellenschaltung mit einer zweiten Schrittgröße abzutasten, um jede Referenzspannung zu erhalten;
die Speicherschnittstellenschaltung einen ersten Signalempfänger umfasst, und das Testergebnis ein erstes Testergebnis umfasst;
die Testergebnis-Ermittlungseinheit (1030) umfasst: eine erste Testergebnis-Ermittlungseinheit, die konfiguriert ist, um das erste Testergebnis des ersten Signalempfängers unter jeder Strobe-to-Data-Zeit und jeder Referenzspannung zu ermitteln;
die Daten-Augendiagramm-Erzeugungseinheit (1040) umfasst: eine erste Signalempfänger-Daten-Augendiagramm-Erzeugungseinheit, die so konfiguriert ist, dass sie das Daten-Augendiagramm des ersten Signalempfängers gemäß dem ersten Testergebnis des ersten Signalempfängers erzeugt, indem sie jede Strobe-to-Data-Zeit als einen ersten Koordinatenwert nimmt und jede Referenzspannung als einen zweiten Koordinatenwert nimmt;
**dadurch gekennzeichnet, dass** die Speicherschnittstellenschaltung einen zweiten Signalempfänger umfasst, und das Testergebnis ein zweites Testergebnis umfasst;
die Testergebnis-Ermittlungseinheit (1030) ferner umfasst: eine zweite Testergebnis-Ermittlungseinheit, die so konfiguriert ist, dass sie das zweite Testergebnis des zweiten Signalempfängers unter jeder Strobe-to-Data-Zeit und jeder Referenzspannung ermittelt;
die Daten-Augendiagramm-Erzeugungseinheit (1040) ferner umfasst: eine zweite Signalempfänger-Daten-Augendiagramm-Erzeugungseinheit, die so konfiguriert ist, dass sie das Daten-Augendiagramm des zweiten Signalempfängers entsprechend dem zweiten Testergebnis des zweiten Signalempfängers erzeugt, indem sie jede Strobe-to-Data-Zeit als einen ersten Koordinatenwert nimmt und jede Referenzspannung als einen zweiten Koordinatenwert nimmt;
die Vorrichtung zum Bewerten der Leistung der Speicherschnittstellenschaltung ferner umfasst: eine zusammengesetzte Schnittstellenschaltungs-Augendiagrammeinheit, die so konfiguriert ist, dass sie ein zusammengesetztes Augendiagramm der Speicherschnittstellenschaltung entsprechend dem Daten-Augendiagramm des ersten Signalempfängers und dem Daten-Augendiagramm des zweiten Signalempfängers erzeugt, wobei ein Zentrum des zusammengesetzten Augendiagramms eine Standard-Ziel-Strobe-to-Data-Zeit ist, so dass unter der Ziel-Strobe-to-Data-Zeit alle DQs einen Test bestehen.

10. Computerlesbares Speichermedium, das ein darauf gespeichertes Programm umfasst, **dadurch gekennzeichnet, dass** das Programm bei Ausführung durch einen Prozessor das Verfahren nach einem der Ansprüche 1 bis 8 implementiert.

## Revendications

1. Procédé pour évaluer les performances d'un circuit d'interface mémoire, le circuit d'interface mémoire étant configuré pour recevoir un signal de données, DQ, en fonction d'un signal d'échantillonnage de données, le procédé comprenant :
analyser une tension de référence du circuit d'interface mémoire pour obtenir chaque tension de référence (S110) ;
analyser les points d'échantillonnage du DQ par le signal d'échantillonnage de données (S120) ;
obtenir un résultat de test du circuit d'interface mémoire à chaque tension de référence et à chaque point d'échantillonnage (S130) ; et
générer un diagramme en oeil des données en fonction du résultat du test (S140) ;
dans lequel l'analyse des points d'échantillonnage du DQ par le signal d'échantillonnage de données (S120) comprend :
analyser une plage de temps échantillon/données du circuit d'interface mémoire avec une première taille de pas pour obtenir chaque temps échantillon/données (S121), le temps échantillon/données représentant la différence de temps entre le signal d'échantillonnage de données et le DQ ;
dans lequel l'analyse d'une tension de référence du circuit d'interface mémoire pour obtenir chaque tension de référence (S110) comprend :
analyser une plage de tension de référence du circuit d'interface mémoire avec une deuxième taille de pas pour obtenir chaque tension de référence ;
dans lequel le circuit d'interface mémoire comprend un premier récepteur de signaux, et le résultat du test comprend un premier résultat de test, dans lequel l'obtention d'un résultat de test du circuit d'interface mémoire sous chaque tension de référence et chaque point d'échantillonnage comprend :
obtenir le premier résultat de test du premier récepteur de signaux pour chaque temps échantillon/données et chaque tension de référence (S131) ; et
générer un diagramme en oeil des données en fonction du résultat du test, comprenant :
en prenant chaque temps échantillon/données comme première valeur de coordonnées et en prenant chaque tension de référence comme deuxième valeur de coordonnées, générer le diagramme en oeil des données du premier récepteur de signaux en fonction du premier résultat de test du premier récepteur de signaux (S141) ;
**caractérisé en ce que** le circuit d'interface mémoire comprend un second récepteur de signaux, et le résultat du test comprend un second résultat de test, dans lequel l'obtention d'un résultat de test du circuit d'interface mémoire sous chaque tension de référence et chaque point d'échantillonnage comprend en outre :
obtenir le deuxième résultat de test du deuxième récepteur de signaux pour chaque temps échantillon/données et chaque tension de référence ; et
générer un diagramme en oeil des données en fonction du résultat du test, comprenant en outre :
en prenant chaque temps échantillon/données comme première valeur de coordonnées et en prenant chaque tension de référence comme seconde valeur de coordonnées, générer le diagramme en oeil des données du second récepteur de signaux en fonction du second résultat de test du second récepteur de signaux ; dans lequel le procédé comprend en outre :
générer un diagramme en oeil composite du circuit d'interface mémoire en fonction du diagramme en oeil des données du premier récepteur de signaux et du diagramme en oeil des données du second récepteur de signaux, un centre du diagramme en oeil composite étant le temps échantillon/données cible par défaut, de sorte que, sous le temps échantillon/données cible, tous les DQ passent un test.

2. Procédé selon la revendication 1, dans lequel la première taille de pas comprend une première taille de sous-pas et une deuxième taille de sous-pas, dans laquelle l'analyse d'une plage de temps échantillon/données du circuit d'interface mémoire avec une première taille de pas pour obtenir chaque temps échantillon/données comprend :
déterminer une plage de temps échantillon/données d'au moins un côté de la plage de temps échantillon/données ;
définir la taille du premier sous-pas de la plage de temps échantillon/données marginale ;
définir une plage de temps échantillon/données médiane dans la plage de temps échantillon/données, à l'exception de la plage de temps échantillon/données marginale ;
définir la deuxième taille de sous-pas de la plage temporelle échantillon/données médiane ; et
analyser la plage de temps échantillon/données marginale avec la première taille de sous-pas, et analyser la plage de temps échantillon/données médiane avec la deuxième taille de sous-pas, afin d'obtenir chaque temps échantillon/données,
dans lequel la première taille de sous-pas est supérieure à la deuxième taille de sous-pas.

3. Procédé selon la revendication 1, dans lequel la deuxième taille de pas comprend une troisième taille de sous-pas et une quatrième taille de sous-pas, dans lequel l'analyse d'une plage de tension de référence du circuit d'interface mémoire avec une deuxième taille de pas pour obtenir chaque tension de référence comprend :
déterminer une plage de tension de référence marginale sur au moins un côté de la plage de tension de référence ;
définir la troisième taille de sous-pas de la plage de tension de référence marginale ;
déterminer une plage de tension de référence médiane dans la plage de tension de référence, à l'exception de la plage de tension de référence marginale ;
définir la quatrième taille de sous-pas de la plage de tension de référence médiane ; et
analyser la plage de tension de référence marginale avec la troisième taille de sous-pas, et analyser la plage de tension de référence médiane avec la quatrième taille de sous-pas, afin d'obtenir chaque tension de référence,
dans lequel la troisième taille de sous-pas est supérieure à la quatrième taille de sous-pas.

4. Procédé selon la revendication 1, dans lequel la génération d'un diagramme en oeil des données en fonction du résultat du test comprend :
utiliser chaque temps échantillon/données comme première valeur de coordonnées et utiliser chaque tension de référence comme deuxième valeur de coordonnées, générer un diagramme bidimensionnel en oeil des données affichant les résultats des tests en fonction des résultats des tests pour chaque temps échantillon/données et chaque tension de référence.

5. Procédé selon la revendication 1, dans lequel la génération du diagramme en oeil des données du premier récepteur de signaux comprend :
obtenir le diagramme en oeil des données du premier récepteur de signaux dans un premier angle de traitement ; et
obtenir le diagramme en oeil des données du premier récepteur de signaux dans un deuxième angle de traitement,
dans lequel le procédé comprend en outre :
générer le diagramme en oeil composite du premier récepteur de signaux en fonction du diagramme en oeil des données du premier récepteur de signaux dans le premier angle de traitement et du diagramme en oeil des données du premier récepteur de signaux dans le deuxième angle de traitement.

6. Procédé selon la revendication 1, comprenant en outre :
comparer le diagramme en oeil des données du premier récepteur de signaux avec le diagramme en oeil des données du second récepteur de signaux et déterminer le décalage entre le premier récepteur de signaux et le second récepteur de signaux, le premier récepteur de signaux et le second récepteur de signaux étant situés dans un même groupe d'octets.

7. Procédé selon la revendication 1, dans lequel le premier récepteur de signaux correspond à une unité de stockage cible dans une mémoire à semi-conducteur, le temps échantillon/données comprend le premier temps échantillon/données, la tension de référence comprend une première tension de référence, le circuit d'interface mémoire comprend en outre une borne de signal d'échantillonnage, et le signal de données comprend des données d'écriture, dans lequel l'obtention du premier résultat de test du premier récepteur de signaux sous chaque temps échantillon/données et chaque tension de référence comprend :
envoyer un signal d'échantillonnage à la borne de signal d'échantillonnage (S1311) ;
après avoir retardé le premier temps échantillon/données, envoyer les données d'écriture au premier récepteur de signaux (S1312) ;
recevoir les données d'écriture en fonction du signal d'échantillonnage et de la première tension de référence et écrire les données d'écriture dans l'unité de stockage cible (S1313) ;
obtenir des données de lecture de l'unité de stockage cible (S1314) ; et
comparer les données d'écriture avec les données de lecture pour obtenir le premier résultat de test du premier récepteur de signaux sous le premier temps échantillon/données et la première tension de référence (S1315).

8. Procédé selon la revendication 7, dans lequel la comparaison des données d'écriture avec les données de lecture pour obtenir le premier résultat de test du premier récepteur de signaux sous le premier temps échantillon/données et la première tension de référence comprend :
si les données d'écriture sont égales aux données de lecture, le premier résultat de test du premier signal sous le premier temps échantillon/données et la première tension de référence est un succès ; et
si les données d'écriture ne sont pas égales aux données de lecture, le premier résultat de test du premier récepteur de signaux sous le premier temps échantillon/données et la première tension de référence est un échec.

9. Appareil pour évaluer les performances d'un circuit d'interface mémoire, le circuit d'interface mémoire étant configuré pour recevoir un signal de données, DQ, en fonction d'un signal d'échantillonnage de données, l'appareil comprenant :
une unité d'analyse de la tension de référence (1010), configurée pour analyser une tension de référence du circuit d'interface mémoire afin d'obtenir chaque tension de référence ;
une unité d'analyse de point d'échantillonnage (1020), configurée pour analyser un point d'échantillonnage du signal d'échantillonnage de données vers le signal de données ;
une unité d'obtention des résultats de test (1030), configurée pour obtenir un résultat de test du circuit d'interface mémoire pour chaque tension de référence et chaque point d'échantillonnage ; et
une unité de génération de diagramme en oeil (1040), configurée pour générer un diagramme en oeil en fonction du résultat du test
dans lequel :
l'unité d'analyse de point d'échantillonnage (1020) comprend une unité d'obtention du temps échantillon/données, configurée pour analyser une plage de temps échantillon/données du circuit d'interface mémoire avec une première taille de pas pour obtenir chaque temps échantillon/données, dans lequel le temps échantillon/données représente la différence de temps entre le signal d'échantillonnage de données et le DQ ;
l'unité d'analyse de la tension de référence (1010) comprend une unité d'obtention de la tension de référence, configurée pour analyser une plage de tension de référence du circuit d'interface mémoire avec une deuxième taille de pas pour obtenir chaque tension de référence ;
le circuit d'interface mémoire comprend un premier récepteur de signaux, et le résultat du test comprend un premier résultat de test ;
l'unité d'obtention des résultats de test (1030) comprend : une première unité d'obtention des résultats de test, configurée pour obtenir le premier résultat de test du premier récepteur de signaux pour chaque temps échantillon/données et chaque tension de référence ;
l'unité de génération du diagramme en oeil des données (1040) comprend : une unité de génération du diagramme en oeil des données du premier récepteur de signaux, configurée pour générer le diagramme en oeil des données du premier récepteur de signaux en prenant chaque temps échantillon/données comme première valeur de coordonnées et en prenant chaque tension de référence comme deuxième valeur de coordonnées, en fonction du premier résultat de test du premier récepteur de signaux ;
**caractérisé en ce que** le circuit d'interface mémoire comprend un second récepteur de signaux, et que le résultat du test comprend un second résultat de test ;
l'unité d'obtention des résultats de test (1030) comprend en outre : une deuxième unité d'obtention des résultats de test, configurée pour obtenir le deuxième résultat de test du deuxième récepteur de signaux pour chaque temps échantillon/données et chaque tension de référence ;
l'unité de génération du diagramme en oeil des données (1040) comprend en outre : une unité de génération du diagramme en oeil des données du deuxième récepteur de signaux, configurée pour, en prenant chaque temps échantillon/données comme première valeur de coordonnées et en prenant chaque tension de référence comme deuxième valeur de coordonnées, générer le diagramme en oeil des données du deuxième récepteur de signaux en fonction du deuxième résultat de test du deuxième récepteur de signaux ;
l'appareil d'évaluation des performances du circuit d'interface mémoire comprend en outre : une unité de diagramme en oeil composite du circuit d'interface, configurée pour générer un diagramme en oeil composite du circuit d'interface mémoire en fonction du diagramme en oeil des données du premier récepteur de signaux et du diagramme en oeil des données du second récepteur de signaux, un centre du diagramme en oeil composite étant le temps échantillon/données cible par défaut, de telle sorte que sous le temps échantillon/données cible, toutes les DQ passent un test.

10. Support de stockage lisible par ordinateur stockant un programme informatique, dans lequel en réponse à l'exécution du programme par un processeur, le procédé selon l'une quelconque des revendications 1 à 8 est mis en oeuvre.
